# EUROPÄISCHE PATENTSCHRIFT

(11) **EP 1 245 985 B1**
(45) Veröffentlichungstag und Bekanntmachung des Hinweises auf die Patenterteilung: **28.01.2004**
(21) Anmeldenummer: 02004367.5
(22) Anmeldetag: 05.03.2002
(51) Int. Cl.: G02B 17/06

(54) **Bildübertragung mit einer Optik vom Offner-Typ**
Image printing device with an optic of the Offner-type
Dispositif d'écriture d'image avec optique de type Offner

(30) Priorität: 30.03.2001 DE 10115875
(43) Veröffentlichungstag der Anmeldung: 02.10.2002
(73) Patentinhaber: Heidelberger Druckmaschinen Aktiengesellschaft, 69115 Heidelberg (DE)
(72) Erfinder: Forrer, Martin, 9008 St. Gallen (CH); Heimbeck, Hans-Jörg, 9435 Heerbrugg (CH); Langenbach, Eckhard, 9037 Speicherschwendi (CH); Vosseler, Bernd, 69120 Heidelberg (DE); Beier, Bernard, Dr., 68526 Ladenburg (DE)

(56) Entgegenhaltungen:
- EP-A- 0 569 718
- EP-A- 0 630 002
- GB-A- 2 332 533
- US-A- 3 748 015
- US-A- 4 428 647
- US-A- 6 104 511

## Beschreibung

Die Erfindung betrifft eine Bebilderungseinrichtung für eine Druckform mit einem Array von Lichtquellen und einer nachgeordneten Mikrooptik, welche ein virtuelles Bild der Lichtquellen erzeugt.

Der Einsatz von Lichtquellenarrays in Reihen oder in Matrixform zur Bebilderung von Druckformen, sei es in einem Druckformbelichter oder in einem Direct Imaging Druckwerk, stellt hohe Anforderungen an die zu verwendende Abbildungsoptik. Typischerweise bestehen die Lichtquellenarrays aus einer bestimmten Anzahl von Diodenlasern, bevorzugt Single-Mode-Lasern, welche in bestimmtem Abstand zueinander, typischerweise im Wesentlichen gleich beabstandet, auf einem Halbleitersubstrat angeordnet sind und welche über eine gemeinsame über die Kristallbruchebene genau definierte Austrittsebene verfügen. Die Lichtemissionskegel dieser Lichtquellen oder Diodenlaser sind in den zwei zueinander im Wesentlichen orthogonal stehenden Symmetrieebenen unterschiedlich weit geöffnet. Daraus ergibt sich die Notwendigkeit einer Abbildungsoptik, welche einerseits diese Asymmetrie mit einer bevorzugt geringen Anzahl von Baugruppen verringert, bevorzugt minimiert, und andererseits eine möglichst abbildungsfehlerfreie globale Abbildung des Arrays von Emittern ermöglicht.

Aus dem Stand der Technik ist eine Reihe von Abbildungsoptiken bekannt, welche speziell für die Abbildung von Diodenlaserreihen zur Bebilderung eines Bildträgers realisiert wurden. Beispielsweise ist aus der US 4,428,647 ein Halbleiterlaserarray bekannt, dessen einzelnen Lasern jeweils eine in der Nähe befindliche Linse zwischen Laserarray und Objektivlinse zugeordnet ist. Der Zweck dieser Linsen ist, den Divergenzwinkel, der aus der Oberfläche des Laserarrays austretenden Lichtstrahlen derart zu verändern, dass das Licht möglichst effizient durch die Objektivlinse gesammelt und auf einen Bildträger fokussiert wird. Die Brechkraft dieser Linsen ist derart gewählt, dass fiir jeden Laser ein virtuelles Zwischenbild hinter der emittierenden Oberfläche erzeugt wird, deren Abstände ungefähr den Abständen der emittierten Lichtstrahlen entsprechen, wobei das Emitterzwischenbild vergrößert ist.

In der EP 0 694 408 B 1 wird zum Beispiel beschrieben, wie eine Mikrooptik mittels axialsymmetrischen optischen Elementen eine Reduktion der Divergenz des austretenden Lichtes erreicht werden kann.

Der oft außergewöhnliche große Unterschied in den lateralen Felddimensionen eines derartigen Lichtquellenarrays, beispielsweise 10 x 0,001 mm², erfordert daher eine spezifische mikroskopische und makroskopische Abbildung. Eine Verwendung von sphärischer Optik für diese Dimensionen ist nur mit einem relativ großen und aufwendigen Optikdesign lösbar. Nachteilig bei der Verwendung sphärischer Makrooptik ist die variable Abbildungsqualität als Funktion des Abstandes zur optischen Achse. Auch der Einsatz von Zylinderlinsen und Zylinderlinsenarrays hat bislang nicht eine Abbildung eines Lichtquellenarrays, insbesondere in Form einer Diodenlaserreihe in gewünschter konstanter Qualität erbracht.

Aus der US 3,748,015 ist ein optisches System zur Formung eines Bildes eines Objektes mit Einheitsvergrößerung und hoher Auflösung bekannt, welche eine Anordnung eines konvexen und eines konkaven sphärischen Spiegels umfasst, deren Krümmungsmittelpunkte an einem Punkt zusammenfallen. Diese Spiegelanordnung erzeugt wenigstens drei Reflexionspunkte innerhalb des Systems und erzeugt zwei von der optischen Achse beabstandete konjugierte Bereiche mit Einheitsvergrößerung in einer Ebene, welche den Krümmungsmittelpunkt enthält, wobei die optische Achse des Systems orthogonal zu dieser Ebene im Krümmungsmittelpunkt ist. Eine derartige Kombination von Spiegeln ist frei von Sphärischer Aberration, Koma und Verzeichnung und, wenn die algebraische Summe der Stärken oder Brechkräfte der benutzten reflektierenden Spiegeloberflächen 0 ist, ist das erzeugte Bild frei von Astigmatismus und Bildfeldwölbung in dritter Ordnung. Eine derartige optisches System wird als optische Anordnung vom Offner-Typ bezeichnet.

In diesem Zusammenhang sei erwähnt, dass beispielsweise in der US 5,592,444 oder EP 0 630 002 A eine Methode mit einer zugehörigen Vorrichtung zum Schreiben und Lesen von Daten auf einem optischen Speichermedium simultan in einer Mehrzahl von Spuren beschrieben wird. Die in diesem Dokument beschriebene Abbildungsoptik für eine Mehrzahl von einzeln ansteuerbaren Diodenlasern umfasst dabei eine Anordnung von sphärischen Spiegeln vom oben beschriebenen Offner-Typ, also eine Kombination aus sphärischen Konkav- und Konvexspiegel mit gemeinsamem Krümmungsmittelpunkt, jedoch wird von der Divergenz reduzierenden Mikrooptik kein virtuelles, insbesondere vergrößertes Zwischenbild erzeugt.

Der Einsatz einer Bebildungseinrichtung für eine Druckform in einem Druckformbelichter oder einem Druckwerk in einer Druckmaschine erfordert jedoch zusätzliche Maßnahmen. Da zum einen der Bauraum in derartigen Maschinen sehr begrenzt ist, zum anderen auch am Aufbau oder an der Konfiguration des Druckformbelichters oder des Druckwerkes für die Implementierung einer Bebilderungseinrichtung wenig abgeändert werden kann, ist eine Reduzierung des benötigten Bauraumes erforderlich. Des Weiteren ist eine Abbildungsoptik an einer Druckmaschine oder einem Druckformbelichter Erschütterungen oder Vibrationen ausgesetzt, sodass sie möglichst wenig Teile aufweisen sollte, welche relativ zueinander justiert werden müssen, sodass aus dem Stand der Technik bekannte optische Anordnungen nicht einfach für die Verwendung an einem Druckformbelichter oder innerhalb eines Druckwerkes einer Druckmaschine übertragen werden können.

Der vorliegenden Erfindung liegt die Aufgabe zugrunde, eine Abbildungsoptik für ein Array von Lichtquellen zu schaffen, sodass eine einfache Verringerung der Divergenz des emittierten Lichtes und eine Abbildung mit geringen Aberrationen ermöglicht wird. Des Weiteren soll eine Abbildungsoptik für eine Bebilderungseinrichtung für eine Druckform mit möglichst geringem Bauraumbedarf und möglichst wenig Teilen, daher möglichst wenig Freiheitsgraden der Justage realisiert werden.

Diese Aufgabe wird durch eine Bebilderungseinrichtung mit den Merkmalen gemäß Anspruch 1 gelöst. Vorteilhafte Ausführungsformen und Weiterbildungen der erfindungsgemäßen Bebilderungseinrichtung sind in den Unteransprüchen charakterisiert.

Die erfindungsgemäße Bebilderungseinrichtung für eine Druckform mit einem Array von Lichtquellen und einer nachgeordneten Mikrooptik, welche ein virtuelles Bild der Lichtquellen erzeugt, zeichnet sich dadurch aus, dass der Mikrooptik eine optische Anordnung, welche wenigstens einen Sektor eines Konkavspiegels und einen Sektor eines Konvexspiegels mit gemeinsamen Krümmungsmittelpunkt umfasst, wobei bevorzugt die algebraische Summe der Stärken der Brechkräfte 0 ist, in anderen Worten eine Makrooptik oder Kombination vom Offner-Typ, nachgeordnet ist, welche ein reelles Bild des virtuellen Zwischenbildes erzeugt. In der Folge wird auch vereinfachend von einer Anordnung eines Konvexspiegels und Konkavspiegels gesprochen, obschon auch wenigstens ein Spiegel nur einen Sektor, welcher sowohl eine einfach als auch nicht-einfach zusammenhängende Fläche definieren kann, in einen bestimmten Teilraumwinkelbereich von maximal 4π aufweisen kann. Die Krümmungsmittelpunkte des Konkavspiegels und des Konvexspiegels müssen dabei in der Realität einer bestimmten Ausführungsform nicht völlig exakt aufeinander liegen, um die gewünschten Eigenschaften der optischen Anordnung vom Offner-Typ in ausreichender Genauigkeit zum Einsatz in einer erfindungsgemäßen Bebilderungseinrichtung zu erlangen.

Unter Einsatz einer geringen Anzahl von optisch refraktiven Flächen wird in der erfindungsgemäßen Bebilderungseinrichtung jede Lichtquelle des Arrays über ein virtuelles Zwischenbild den mikroskopischen Anforderungen, also insbesondere der Divergenz angepasst. Eine nachgeordnete makroskopische Abbildung unter Ausnutzung bekannter Eigenschaften einer optischen Anordnung vom Offner-Typ, also eine Kombination wenigstens eines Sektors eines Konvexspiegels und eines Sektors eines Konkavspiegels mit gemeinsamen Krümmungsmittelpunkt, erlaubt eine vorteilhafte Abbildung von Punkten entlang einer Linie, welche im wesentlichen kreisförmig verläuft. Die optische Anordnung, welcher der Mikrooptik als Makrooptik nachgeordnet ist, der erfindungsgemäßen Bebilderungseinrichtung ist dabei derart ausgeführt, dass die virtuellen Zwischenbildpunkte der Lichtquellen, welche im Wesentlichen auf einer Reihe angeordnet sind, einen geringen Abstand zu dieser Kreislinie aufweisen. Mit anderen Worten: Die erfindungsgemäße Bebilderungseinrichtung ermöglicht eine konstante Emissionskorrektur einer Vielzahl von Lichtquellen, insbesondere Diodenlasern, mit einer geringen Anzahl optischer Elemente. Durch eine Kombination von Zylinderlinsen wird eine mikrooptische Symmetriesierung bei gleichzeitiger Vergrößerung mittels eines virtuellen Zwischenbildes jeder Lichtquelle erreicht und durch eine möglichst aberrationsfreie Abbildung dieser virtuellen Zwischenbilder in ein reelles Bild mittels einer nachgeordneten optischen Anordnung eines Konvexspiegels und eines Konkavspiegels wird eine Bebilderungseinrichtung für eine Druckform mit besonders vorteilhaften Abbildungseigenschaften geschaffen.

Zu einer Anpassung der Divergenz des emittierten Lichtes der Lichtquellen ist die Mikrooptik bevorzugt asphärisch ausgeführt. Beispielsweise kann es sich dabei um Zylinderlinsen oder eine Kombination anamorphotischer Prismen handeln. Die nachgeordnete makroskopische optische Anordnung eines Konvexspiegels und eines Konkavspiegels weist wenigstens ein Kreissegment einer rotationssymmetrischen Optik auf, zu deren zugeordneter Gegenstandskreislinie die im Wesentlichen gradlinig verlaufenden Projektion der Reihe der virtuellen Zwischenbildpunkte einen gering gehaltenen Abstand aufweist, wobei die Gegenstandskreislinie innerhalb eines der zwei konjugierten Bereiche der optischen Anordnung eines Konvexspiegels und eines Konkavspiegels liegt. Damit ist es möglich, mittels der optischen Anordnung vom Offner-Typ die im Wesentlichen gradlinig verlaufende Reihe der virtuellen Zwischenbildpunkte in den zweiten konjugierten Bereich reell mit Einheitsvergrößerung abzubilden. Besonders vorteilhaft ist dabei die Aberrationsfreiheit der optischen Anordnung eines Konvexspiegels und eines Konkavspiegels.

Zur Verringerung des Bauraumbedarfs der erfindungsgemäßen Bebilderungseinrichtung ist es vorteilhaft, wenigstens eine Faltung des Strahlengangs innerhalb der optischen Anordnung eines Konvexspiegels und eines Konkavspiegels vorzunehmen. Vorteilhafterweise wird daher wenigstens eine Lichtumlenkfläche in der der Mikrooptik nachgeordneten optischen Anordnung, sei es vor und/oder nach den reflektiven Flächen der optischen Anordnung eines Konvexspiegels und eines Konkavspiegels vorgesehen. Dadurch wird der Strahlengang durch die Abbildungsoptik der erfindungsgemäßen Bebilderungseinrichtung kompakt, sodass für eine Realisierung innerhalb eines Druckformbelichters oder eines Druckwerkes eine Bauraumverringerung möglich ist. Darüber hinaus kann mit besonderem Vorteil die Gestaltung wenigstens eines Teils der optischen Anordnung eines Konvexspiegels und eines Konkavspiegels als ein einzelnes Bauteil, also monolithisch aus einem geeigneten Material mit einem Brechungsindex verschieden von der Umgebung, beispielsweise aus einem Glas oder einem anderen transparenten Material, vorgenommen werden. Das einzelne Bauteil bzw. der Monolith kann dann zum Teil nach innen verspiegelte Flächen aufweisen, welche beispielsweise die konkave bzw. konvexe reflektive Fläche der optischen Anordnung eines Konvexspiegels und eines Konkavspiegels realisieren. Diese Innenflächen werden auch als aktive innere Flächen des Monolithen bezeichnet. Am Monolithen sind wenigstens ein Ein- und ein Austrittsfenster für das von wenigstens einer Lichtquelle emittierte Licht vorgesehen, welche bevorzugt mit einer Antireflexbeschichtung in Form eines Interferenzfilters versehen sind. In einer vorteilhaften Weiterbildung können dem monolithischen Aufbau weitere optische Elemente, wie Prismen oder Lichtumlenkflächen zur Strahlumlenkung zugeordnet sein.

Mit besonderem Vorteil kann eine erfindungsgemäße Bebilderungseinrichtung in einem Druckformbelichter oder in einem Druckwerk zum Einsatz gelangen. Eine erfindungsgemäße Druckmaschine, welche einen Anleger, wenigstens ein Druckwerk und einen Ausleger umfasst, zeichnet sich dadurch aus, dass diese Druckmaschine wenigstens ein Druckwerk mit einer erfindungsgemäßen Bebilderungseinrichtung aufweist.

Weitere Vorteile und vorteilhafte Ausführungsformen und Weiterbildungen der Erfindung werden anhand der nachfolgenden Figuren sowie deren Beschreibungen dargestellt. Es zeigt im Einzelnen:
- Figur 1: eine schematische Darstellung einer Konfiguration optischer Elemente in einer Ausführungsform der erfindungsgemäßen Bebilderungseinrichtung für eine Druckform,
- Figur 2: eine schematische Darstellung einer Konfiguration optischer Elemente in einer alternativen Ausführungsform der erfindungsgemäßen Bebilderungseinrichtung mit zusätzlichen Strahlprofilfilter,
- Figur 3: eine schematische Darstellung zur Erläuterung der Lage von Fokallinie der optischen Anordnung von Konvexspiegel und Konkavspiegel zur Reihe der virtuellen Bildpunkte des Arrays von Lichtquellen,
- Figur 4: eine schematische Darstellung einer monolithisch aufgebauten optischen Anordnung eines Konvexspiegels und eines Konkavspiegels,
- Figur 5: eine schematische Darstellung einer monolithisch ausgeführten alternativen optischen Anordnung eines Konvexspiegels und eines Konkavspiegels unter Ausnutzung von zwei Strahlfaltungen,
- Figur 6: eine schematische Darstellung einer symmetrischen monolithisch ausgeführten alternativen optischen Anordnung eines Konvexspiegels und eines Konkavspiegels mit zusätzlichen Strahlumlenkelementen in Form von Prismen und
- Figur 7: eine schematische Darstellung einer weiteren Alternative monolithisch ausgeführten optischen Anordnung eines Konvexspiegels und eines Konkavspiegels mit einer konvexen Sphäre und einem Prisma zur Einkoppelung des abzubildenden Lichtes.

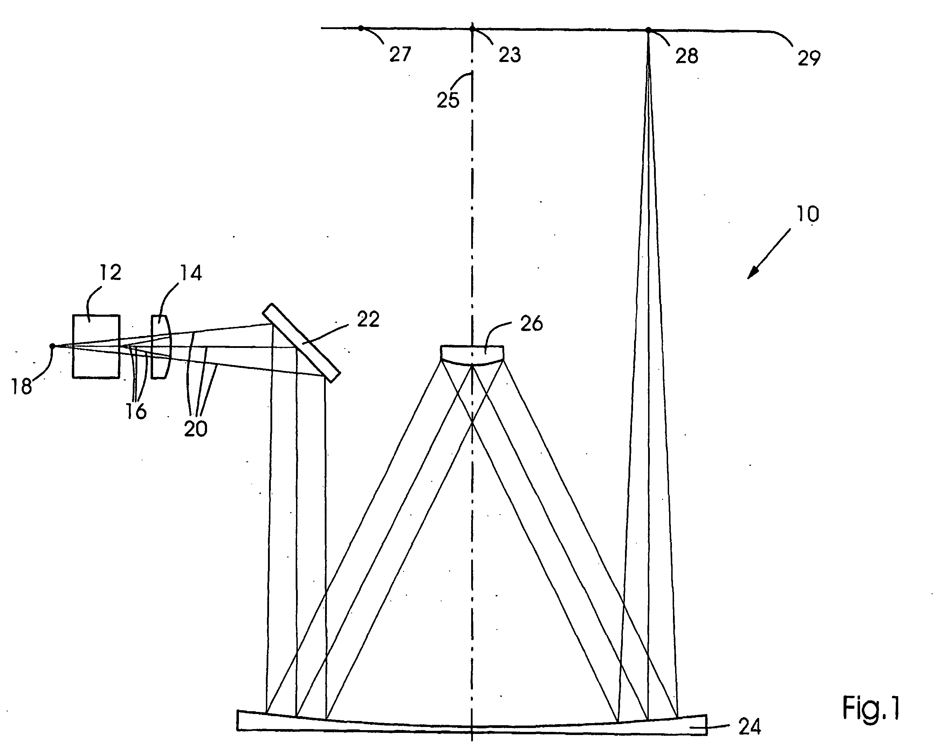

Die Figur 1 zeigt eine schematische Darstellung einer Konfiguration optischer Elemente in einer Ausführungsform der erfindungsgemäßen Bebilderungseinrichtung für eine Druckform. Die erfindungsgemäße Bebilderungseinrichtung weist eine Lichtquelle 12 mit einer zugeordneten Mikrooptik 14 und eine nachgeordnete optische Anordnung 10 auf. Das von der Lichtquelle 12 emittierte divergente Licht 16 wird durch die Mikrooptik 14 auf ein virtuelles Bild 18 abgebildet. Durch die nachgeordnete optische Anordnung 10 werden die Lichtstrahlen 20 ausgehend vom virtuellen Zwischenbild 18 über verschiedene optische Elemente in einen reellen Bildpunkt 28 transformiert. Die optische Anordnung 10 weist in dieser Ausführungsform zunächst ein Umlenkelement 22 und ein entlang der optischen Achse 23 und dazu rotationssymmetrisch ausgeführtes Paar von Spiegeln, dem Konkavspiegel 24 und dem Konvexspiegel 26 mit gemeinsamem Krümmungsmittelpunkt 25 entlang der optischen Achse 23 auf. Dieses aus Konkavspiegel 24 und Konvexspiegel 26 gebildete Paar bildet Punkte in einem Gegenstandsbereich auf Punkte in einem Bildbereich ab. Diese Bereiche sind zueinander konjugiert. Durch das zusätzliche Umlenkelement 22 ist die Symmetrie des Strahlenganges durch die optische Anordnung 10 gebrochen, sodass dem Bildpunkt 28 als konjugierter Punkt das virtuelle Zwischenbild 18 und nicht der konjugierte Punkt ohne Umlenkelement 27 in der Druckformebene 29 zugeordnet ist. Die optische Weglänge zwischen dem virtuellen Zwischenbild 18 und dem Konkavspiegel 24 ist aber gleich der optischen Länge zwischen Konkavspiegel 24 und Bildpunkt 28 in der Druckformebene 29.

Während in der Figur 1 die Abbildung einer Lichtquelle 12 mit einer Mikrooptik 14 und einer nachgeordneten optischen Anordnung 10, also einer Makrooptik, zeichnerisch zum besseren Verständnis der erfindungsgemäßen Bebilderungseinrichtung dargestellt ist, wird mittels einer entsprechenden bevorzugten Ausführungsform der Erfindung eine Mehrzahl von Lichtquellen 12, welche typischerweise in Reihe angeordnet sind, durch eine bevorzugt für jede Lichtquelle 12 individuell ausgeprägte Mikrooptik 14 und eine auf die Mehrzahl der Zwischenbilder 18 wirkende Makrooptik, der optischen Anordnung 10 eines Konvexspiegels und eines Konkavspiegels entsprechend, abgebildet.

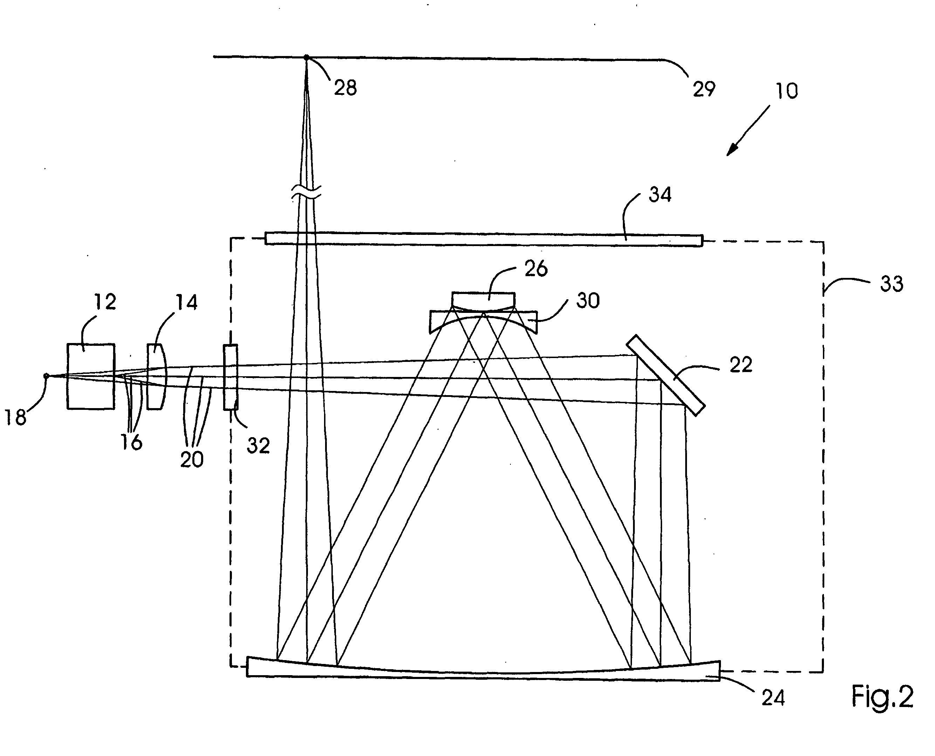

In der Figur 2 ist eine schematische Darstellung einer Konfiguration optischer Elemente in einer alternativen Ausführungsform der erfindungsgemäßen Bebilderungseinrichtung für eine Druckform mit zusätzlichem Strahlprofilfilter gezeigt. Die erfindungsgemäße Bebilderungseinrichtung umfasst dabei eine Lichtquelle 12, eine Mikrooptik 14, ein Eintrittsfenster 32 in eine Kapselung 33, in welcher sich die optische Anordnung 10 befindet, und ein Austrittsfenster 34 mit nachgeordneter Druckform 29. Die optische Anordnung 10 umfasst dabei ein Umlenkelement 22, einen Konkavspiegel 24, ein Wellenfrontkorrekturelement oder Strahlformungselement 30, ein sogenanntes Strahlprofilfilter, bevorzugt zur Transmission der Fundamentalmode der Lichtquelle 12, beispielsweise mit einem Gaußschen Strahlprofil, und einem Konkavspiegel 26. Die optische Anordnung 10 ist also ebenfalls eines Konvexspiegels und eines Konkavspiegels mit konjugierten Bereichen, wobei das virtuelle Zwischenbild 18, erzeugt aus dem divergenten Licht 16 der Lichtquelle 12 mittels der Mikrooptik 14, im ersten konjugierten Bereich und dem Bildpunkt 28 in der Druckformebene 29 im zweiten konjugierten Bereich. Durch die gezeigte Faltung des Strahlenganges durch Verwendung des Umlenkelementes 22, sei es wie hier in Figur 2 gezeigt vor dem Konvexspiegel 26 vorbei, den Strahlengang zwischen Konvexspiegel 26 und Konkavspiegel 24 kreuzend, oder alternativ dazu hinter dem Konvexspiegel vorbei ist es möglich, einen noch kompakteren Aufbau zu erreichen.

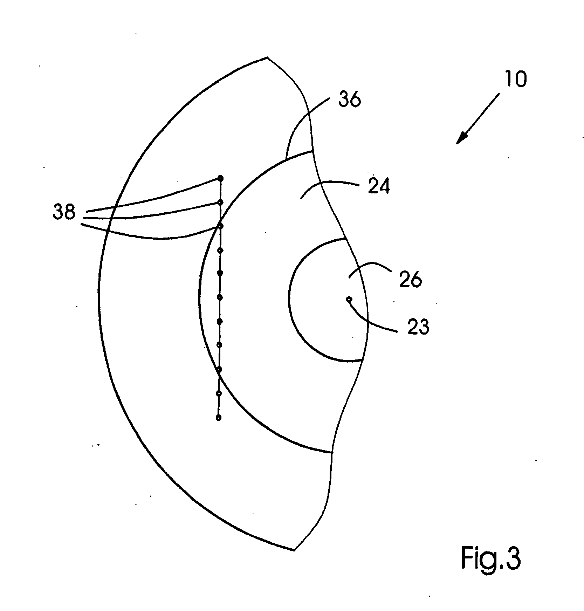

Die Figur 3 dient mit einer schematischen Darstellung der Erläuterung der Lage einer Fokallinie, d. h. ausgewählten Punkten im ersten konjugierten Bereich der optischen Anordnung eines Konvexspiegels und eines Konkavspiegels, zur Reihe der virtuellen Bildpunkte des Arrays von Lichtquellen. Gezeigt ist in der Figur 3 eine Projektion entlang der optischen Achse 23 des Konkavspiegels 24 und des Konvexspiegels 26 der optischen Anordnung 10. Die im Wesentlichen kreisförmige Fokallinie 36 repräsentiert die Projektion der konjugierten Bereiche auf den Konkavspiegel 24 für den Fall eines hier beispielhaft gewählten symmetrischen Strahlenganges. In anderen Worten: Gegenstandspunkt und Bildpunkt der optischen Anordnung eines Konvexspiegels und eines Konkavspiegels liegen im Wesentlichen gegenphasig auf einer kreisförmigen Fokallinie 36, also 180 Grad entgegengesetzt um die optische Achse 23. Die Fokallinie 36 beschreibt im Wesentlichen diejenigen Punkte mit extremal vorteilhafter Transformationseigenschaft, also mit minimierten Aberrationen. Ziel ist es nun, die Reihe der virtuellen Bildpunkte 38 dieser Fokallinie 36 möglichst anzunähern. Dabei ist es im Zusammenhang der Erfindung unerheblich, welche genaue Metrik oder welches Maß zur Messung des Abstandes der Linie 38 zum Kreissegment 36 gewählt wird. Beispielhaft kann der mittlere Abstand der Lichtquellen in der Projektion 38 zur optischen Achse 23, also die Summe der Abstände geteilt durch die Anzahl der Lichtquellen, als ein Maß herangezogen werden. Zur Erreichung einer vorteilhaft aberrationsminimierten Abbildung durch die optische Anordnung 10 wird der Abstand der Projektion der Reihe der virtuellen Bildpunkte 38 zum Radius der Fokallinie 36 gering gehalten oder angepasst.

Des Weiteren ist klar, dass die optische Anordnung 10 eines Konvexspiegels und eines Konkavspiegels derart ausgelegt werden soll, dass die Projektion der Fokallinie 36 einen möglichst großen Krümmungsradius aufweist. In anderen Worten: Lokal gesehen, also auf der Skala des Abstandes maximal voneinander entfernten Bildpunkte der Lichtquellen in der Projektion der Lichtquellen 38 gesehen, soll die Fokallinie 36 im Vergleich zur Projektion der Reihe der Lichtquellen 38 möglichst flach verlaufen. Die eingesetzte optische Anordnung 10 braucht also nur wenigstens ein Kreissegment einer rotationssymmetrischen Optik eines Konvexspiegels und eines Konkavspiegels aufzuweisen.

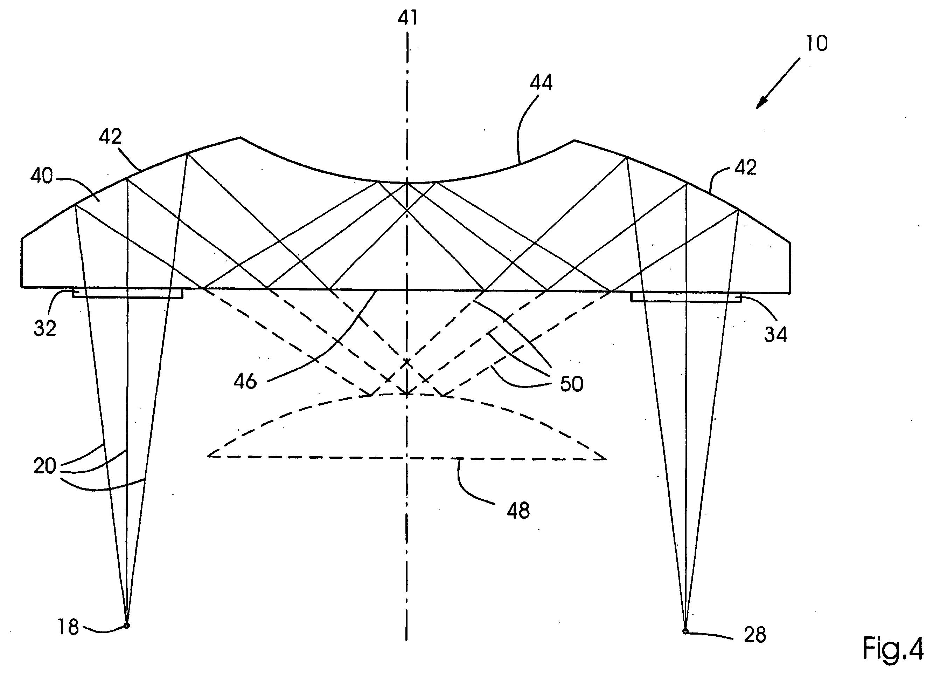

In der Figur 4 ist eine schematische Darstellung einer monolithisch aufgebauten Ausführungsform der optischen Anordnung in der erfindungsgemäßen Bebilderungseinrichtung gezeigt. Durch einen monolithischen Aufbau soll eine weitere Verkleinerung der optischen Anordnung eines Konvexspiegels und eines Konkavspiegels erreicht werden. Gezeigt ist in der Figur 4 beispielhaft zur Erläuterung eines derartigen monolithischen Aufbaus ein symmetrischer Strahlengang. Die optische Anordnung 10 ist symmetrisch zur Achse 41. Ausgehend vom virtuellen Zwischenbild 18 der hier nicht gezeigten Lichtquelle nebst Mikrooptik treten Lichtstrahlen 20 durch ein Eintrittsfenster 32 in einen Monolithen 40, welcher beispielhaft aus einem hochbrechenden Glas oder einem für die verwendete Wellenlänge transparenten Polymer besteht. Der Monolith weist eine Konkavfläche 42 auf, welche die Lichtstrahlen 20 spiegelt, sodass sie auf eine im Wesentlichen plane Spiegelfläche 46, der Konkavfläche 42 gegenüberliegend treffen. Von der Spiegelfläche 46 werden die Strahlen auf eine Konvexfläche 44 geworfen, von welcher ausgehend symmetrisch auf der anderen Seite der Symmetrieachse 41 wiederum die Spiegelfläche 46 und anschließend die Konkavfläche 42 von den Lichtstrahlen getroffen wird, bis diese durch ein Austrittsfenster 34 den Monolithen verlassen und in einen Bildpunkt 28, zweckmäßigerweise in der hier nicht gezeigten Druckformebene, konvergieren. Der monolithische Aufbau, wie er in dieser Figur 4 gezeigt ist, nutzt aus, dass in einer optischen Anordnung eines Konvexspiegels und eines Konkavspiegels vor allem diejenigen Bereiche des Konkavspiegels, welche entfernt von der optischen Achse oder Symmetrieachse 41 liegen, zur Reflektion vom ersten konjugierten Bereich auf den Konvexspiegel und vom Konvexspiegel in den zweiten konjugierten Bereich genutzt werden. Dadurch ist es möglich, eine spiegelnde Fläche 46 einzuführen, sodass die Konkavfläche 42 in der Nähe der optischen Achse oder Symmetrieachse 41 durch eine Konvexfläche 44 ersetzt werden kann. Die Lage und die Krümmung ist selbstverständlich durch die Bedingungen einer optischen Anordnung eines Konvexspiegels und eines Konkavspiegels bestimmt. Die Konvexfläche 44 entspricht einem Konvexspiegel an der Position 48, auf den die Lichtstrahlen 20 entlang der Lichtwege 50 ohne spiegelnde Fläche 46 treffen würde. Während die Seiten des Monolithen 40, an denen die Lichtstrahlen 20 reflektiert werden sollen, durch geeignete Beschichtungen, sei es durch eine Metallschicht oder durch Interferenzfilter, möglichst reflektiv gemacht werden, ist für das Eintrittsfenster 32 und/oder das Austrittsfenster 34 eine Antireflexbeschichtung, beispielsweise durch ein Interferenzfilter, vorgesehen, sodass eine möglichst starke Ein- bzw. Auskopplung des Lichtes in bzw. aus dem Monolithen ermöglicht wird.

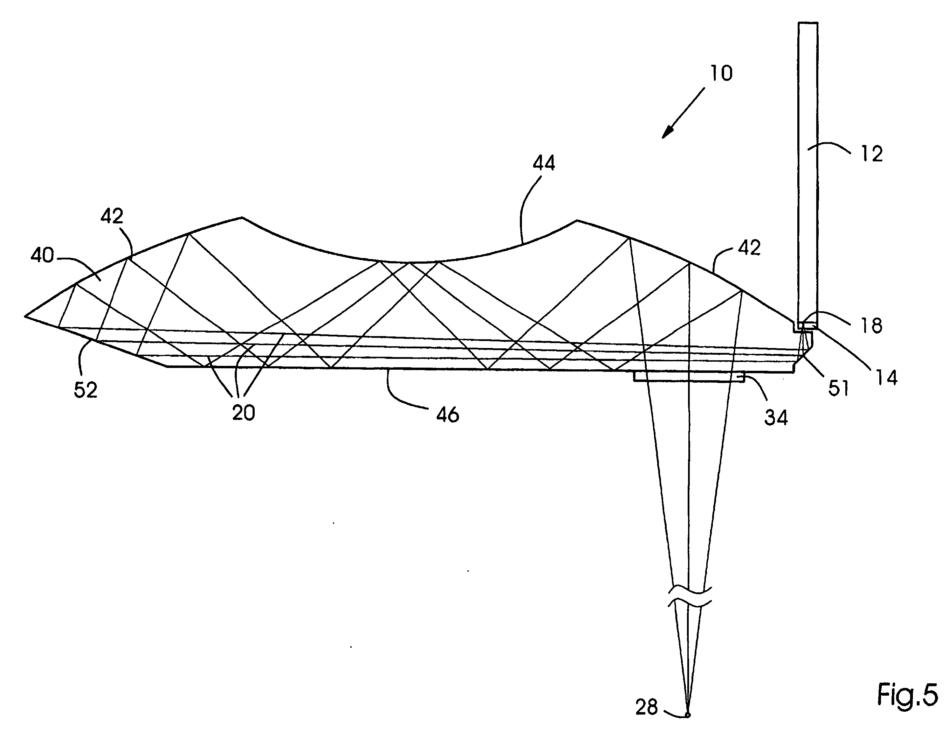

In der Figur 5 ist eine schematische Darstellung einer monolithisch ausgeführten alternativen optischen Anordnung eines Konvexspiegels und eines Konkavspiegels unter Ausnutzung von Zweistrahlfaltungen gezeigt. Eine Lichtquelle 12 wird mittels einer Mikrooptik 14 in ein virtuelles Zwischenbild 18 transformiert. Die von diesem virtuellen Zwischenbild 18 ausgehenden Lichtstrahlen 20 treten in den Monolithen 40 ein und werden an einer ersten Umlenkfläche 51 und einer zweiten Umlenkfläche 52 auf eine Konkavfläche 42 projiziert. Die Lichtstrahlen 20 treffen dann auf eine Spiegelfläche 46, auf eine Konvexfläche 44, erneut auf die Spiegelfläche 46 und auf die Konkavfläche 42, um dann den Monolithen 40 durch ein Austrittsfenster 34 zu verlassen und in einem Bildpunkt 28 zu konvergieren.

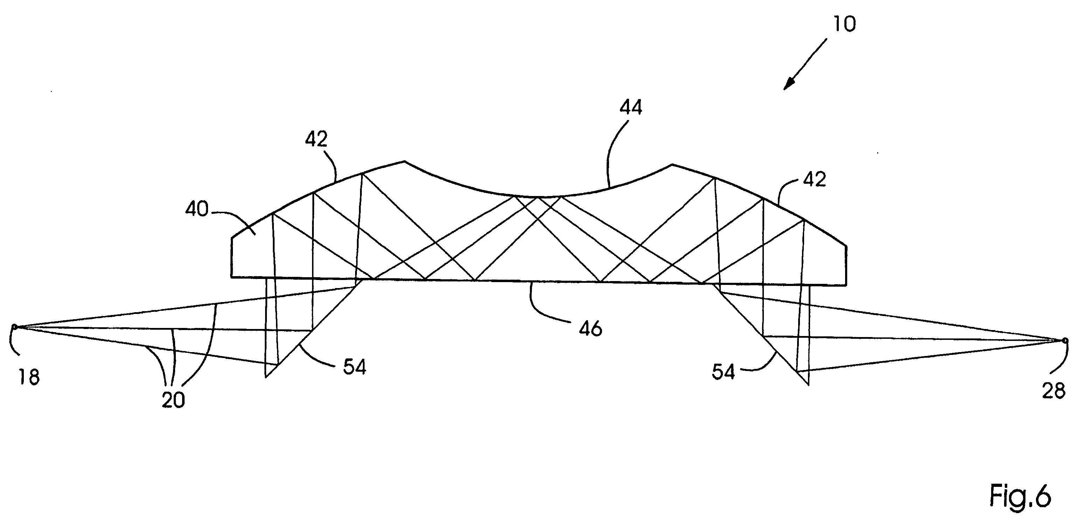

Eine symmetrisch ausgeführte alternative optische Abbildung eines Konvexspiegels und eines Konkavspiegels ist in der Figur 6 schematisch dargestellt, wobei zusätzlich Umlenkelemente in prismatischer Form verwendet werden. Vom virtuellen Zwischenbild 18 der hier nicht gezeigten Lichtquelle 12 ausgehende Lichtstrahlen 20 treten in ein prismatisches Umlenkelement 54, an dessen Basis sie reflektiert werden, ein und gelangen in den Monolithen 40. Es ist ein symmetrischer Strahlengang vorgesehen, die Lichtstrahlen 20 treffen zunächst auf eine Konkavfläche 42, eine Spiegelfläche 46, eine Konvexfläche 44, erneut auf die Spiegelfläche 46 und auf die Konkavfläche 42. Anschließend ist ebenfalls ein prismatisches Umlenkelement 54 vorgesehen, an dessen Basis die Lichtstrahlen 20 total reflektiert werden. Das Licht konvergiert in einen Bildpunkt 28.

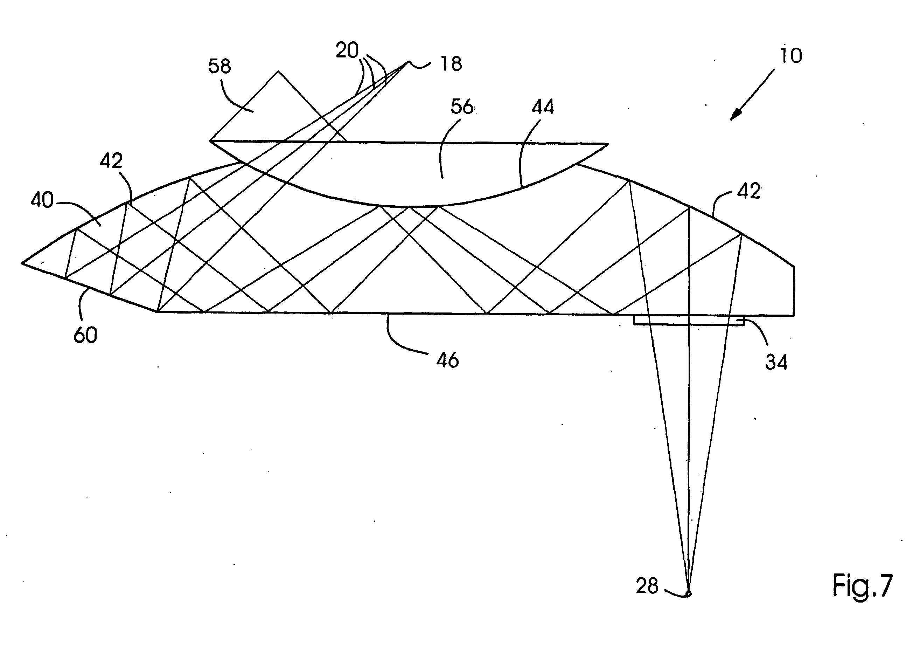

In der Figur 7 ist eine schematische Darstellung einer weiteren alternativen monolithisch ausgeführten optischen Anordnung eines Konvexspiegels und eines Konkavspiegels mit einer zusätzlichen konvexen Sphäre und einem Prisma zur Einkoppelung des abzubildenden Lichtes gezeigt. Das von einem virtuellen Zwischenbild 18, einer hier nicht gezeigten Lichtquelle nebst Mikrooptik Licht 20 tritt in ein Prisma 58 und von dort in eine konvexe Sphäre 56. Es ist ein Bereich in deren Oberfläche vorgesehen, durch den die Lichtstrahlen 20 möglichst reflexionsfrei in den Monolithen 40 eintreten können. Die Lichtstrahlen 20 werden an die diversen Innenflächen des Monolithen reflektiert. Diese Innenflächen umfassen die Facette 60, eine Konkavfläche 42, eine Spiegelfläche 46 und eine Konvexfläche 44. Der Strahlengang des Lichtes 20 bis zum Bildpunkt 28 ist angedeutet. Das Licht kann den Monolithen 40 durch ein Austrittsfenster 34 verlassen. Typischerweise ist die Konvexfläche 44 verspiegelt, sodass Licht innerhalb des Monolithen 40 reflektiert wird.

### Bezugszeichenliste

- 10: optische Anordnung
- 12: Lichtquelle
- 14: Mikrooptik
- 16: divergentes Licht
- 18: virtuelles Zwischenbild
- 20: Lichtstrahl
- 22: Umlenkelement
- 23: optische Achse
- 24: Konkavspiegel
- 25: Krümmungsmittelpunkt
- 26: Konvexspiegel
- 27: konjugierter Punkt ohne Umlenkelement
- 28: Bildpunkt
- 29: Druckformebene
- 30: Strahlformungselement
- 32: Eintrittsfenster
- 33: Kapselung
- 34: Austrittsfenster
- 36: Projektion der Fokallinie
- 38: Projektion der Lichtquellen
- 40: Monolith
- 41: Symmetrieachse
- 42: Konkavfläche
- 44: Konvexfläche
- 46: Spiegelfläche
- 48: Position des Konvexspiegels
- 50: Lichtstrahlen ohne spiegelnde Fläche
- 51: erste Umlenkfläche
- 52: zweite Umlenkfläche
- 54: prismatisches Umlenkelement
- 56: konvexe Sphäre
- 58: Prisma
- 60: Facette

## Patentansprüche

1. Bebilderungseinrichtung für eine Druckform (29) mit einem Array von Lichtquellen (12) und einer nachgeordneten Mikrooptik (14) mit einer Anzahl von optisch refraktiven Flächen und einer optischen Anordnung (10), welche wenigstens einen Sektor eines Konvexspiegels (26) und einen Sektor eines Konkavspiegels (24) mit gemeinsamen Krümmungsmittelpunkt und mit einem ersten und einem zweiten konjugierten Bereich umfasst und welche ein reelles Bild (28) des ersten konjugierten Bereichs im zweiten konjugierten Bereich erzeugt,
**dadurch gekennzeichnet,**
**dass** die Mikrooptik (14) ein virtuelles Zwischenbild (18) der Lichtquellen (12) erzeugt und dass die optische Anordnung (10) der Mikrooptik (14) derart nachgeordnet ist, dass das virtuelle Zwischenbild (18) im ersten konjugierten Bereich liegt.

2. Bebilderungseinrichtung für eine Druckform (29) gemäß Anspruch 1,
**dadurch gekennzeichnet,**
**dass** das virtuelle Zwischenbild (18) eine vergrößerte Abbildung der Lichtquellen (12) ist.

3. Bebilderungseinrichtung für eine Druckform (29) gemäß Anspruch 1 oder 2,
**dadurch gekennzeichnet,**
**dass** die optisch refraktiven Flächen der Mikrooptik (14) für eine Anpassung der Divergenz des emittierten Lichtes (16) der Lichtquellen asphärisch sind.

4. Bebilderungseinrichtung für eine Druckform (29) gemäß einem der vorhergehenden Ansprüche,
**dadurch gekennzeichnet,**
**dass** die optische Anordnung (10) eines Konvexspiegels (26) und eines Konkavspiegels (24) wenigstens ein Kreissegment einer rotationssymmetrischen Optik aufweist, zu dessen zugeordneter Gegenstandskreislinie (36) die im Wesentlichen gradlinig verlaufende Projektion der Reihe der virtuellen Zwischenbildpunkte (38) einen gering gewählten Abstand aufweist.

5. Bebilderungseinrichtung für eine Druckform (29) gemäß einem der vorhergehenden Ansprüche,
**dadurch gekennzeichnet,**
**dass** wenigstens ein Lichtumlenkelement (22) vor und/oder nach den reflektiven Flächen der optischen Anordnung (10) eines Konvexspiegels (26) und eines Konkavspiegels (24) und/oder ein Strahlformungselement (30) zwischen den reflektiven Flächen der optischen Anordnung (10) eines Konvexspiegels und eines Konkavspiegels vorgesehen ist.

6. Bebilderungseinrichtung für eine Druckform (29) gemäß einem der vorhergehenden Ansprüche,
**dadurch gekennzeichnet,**
**dass** die optische Anordnung (10) wenigstens teilweise monolithisch aufgebaut ist.

7. Bebilderungseinrichtung für eine Druckform (29) gemäß Anspruch 6,
**dadurch gekennzeichnet,**
**dass** die aktiven inneren Flächen des Monolithen (40) verspiegelt sind.

8. Bebilderungseinrichtung für eine Druckform (29) gemäß Anspruch 6 oder Anspruch 7,
**dadurch gekennzeichnet,**
**dass** wenigstens ein Eintrittsfenster (32) und ein Austrittsfenster (34) mit Antireflexschichten vorgesehen sind.

9. Bebilderungseinrichtung für eine Druckform (29) gemäß einem der Ansprüche 6 bis 8,
**dadurch gekennzeichnet,**
**dass** dem monolithischen Aufbau (40) weitere optische Elemente (54, 56, 58) zur Strahlumlenkung und/oder Strahlformung und/oder Wellenfrontkorrektur zugeordnet sind.

10. Bebilderungseinrichtung für eine Druckform (29) gemäß einem der Ansprüche 6 bis 9,
**dadurch gekennzeichnet,**
**dass** der Monolith (40) ein Glas mit einem hohen Brechungsindex im Vergleich zu seiner Umgebung aufweist.

11. Druckformbelichter,
**dadurch gekennzeichnet,**
**dass** der Druckformbelichter wenigstens eine Bebilderungseinrichtung gemäß einem der vorhergehenden Ansprüche umfasst.

12. Druckwerk,
**dadurch gekennzeichnet,**
**dass** das Druckwerk wenigstens eine Bebilderungseinrichtung gemäß einem der vorhergehenden Ansprüche umfasst.

13. Druckmaschine mit einem Anleger, wenigstens einem Druckwerk und einem Ausleger,
**dadurch gekennzeichnet,**
**dass** die Druckmaschine wenigstens ein Druckwerk gemäß Anspruch 12 aufweist.

## Claims

1. Image-recording device for a printing form (29) with an array of light sources (12) and a subsequent micro-optics (14) with a number of optically refractive surfaces and an optical system (10), which at least includes a sector of a convex mirror (26) and a sector of a concave mirror (24), the two having a common centre of curvature and a first and a second conjugate region, and which creates a real image (28) of the first conjugate region in the second conjugate region,
**characterized in**
**that** the micro-optics (14) generates a virtual intermediate image (18) of the light sources (12) and that the optical system (10) is arranged downstream of the micro-optics (14) in such a way that the virtual intermediate image (18) is located in the first conjugate region.

2. Image-recording device for a printing form (29) according to Claim 1,
**characterized in**
**that** the virtual intermediate image (18) is an enlarged representation of the light sources (12).

3. Image-recording device for a printing form (29) according to claim 1 or 2,
**characterized in**
**that** the optically refractive surfaces of the micro-optics (14) are aspherical for an adaptation of the divergence of the emitted light (16) of the light sources.

4. Image-recording device for a printing form (29) according to one of the preceding claims,
**characterized in**
**that** the optical arrangement (10) of a convex mirror (26) and a concave mirror (24) comprises at least one circular segment of a rotationally symmetrical optics, and that the distance of the substantially linear projection of the row of virtual intermediate image points (38) from the circular focal line (36) assigned to said circular segment is selected to be small.

5. Image-recording device for a printing form (29) according to one of the preceding claims,
**characterized in**
**that** at least one light deflection element (22) is provided upstream and/or downstream of the reflective surfaces of the optical arrangement (10) of a convex mirror (26) and a concave mirror (24) and/or that a beam-forming element (30) is provided between the reflective surfaces of the optical arrangement (10) of a convex mirror and a concave mirror.

6. Image-recording device for a printing form (29) according to one of the preceding claims,
**characterized in**
**that** the optical arrangement (10) is designed at least in a partially monolithic way.

7. Image-recording device for a printing form (29) according to claim 6,
**characterized in**
**that** the active inner surfaces of the monolith (40) are reflective.

8. Image-recording device for a printing form (29) according to claim 6 or claim 7,
**characterized in**
**that** at least one entry window (32) and one exit window (34) having antireflective layers are provided.

9. Image-recording device for a printing form (29) according to one of claims 6 to 8,
**characterized in**
**that** the monolithic structure (40) is assigned further optical elements (54, 56, 58) for deflecting beams and/or forming beams and/or correcting the wavefront.

10. Image-recording device for a printing form (29) according to one of claims 6 to 9,
**characterized in**
**that** the monolith (40) has a glass with a high refractive index compared to its environment.

11. Printing form exposure unit,
**characterized in**
**that** the printing form exposure unit comprises at least one image-recording device according to one of the preceding claims.

12. Printing unit,
**characterized in**
**that** the printing unit comprises at least one image-recording device according to one of the preceding claims.

13. Printing press having a feeder, at least one printing unit, and a delivery,
**characterized in**
**that** the printing press has at least one printing unit according to claim 12.

## Revendications

1. Dispositif de formation d'image pour une forma d'impression (29), comprenant un réseau de sources de lumière (12) auquel succède une micro-optique (14) avec un certain nombre de surfaces optiquement réfringentes, et un agencement optique (10) qui comporte au moins un secteur d'un miroir convexe (26) et un secteur d'un miroir concave (24) avec un centre de courbure commun et avec un premier et un second domaine conjugué, et qui engendre une image réelle (28) du premier domaine conjugué dans le second domaine conjugué,
**caractérisé en ce que** la micro-optique (14) engendre une image intermédiaire virtuelle (18) des sources de lumière (12), et **en ce que** l'agencement optique (10) succède à la micro-optique (14) de façon telle que l'image intermédiaire virtuelle (18) se situe dans le premier domaine conjugué.

2. Dispositif de formation d'image pour une forme d'impression (29), selon la revendication 1, **caractérisé en ce que** l'image intermédiaire virtuelle (18) est une reproduction agrandie des sources de lumière (12).

3. Dispositif de formation d'image pour une forme d'impression (29), selon la revendication 1 ou 2, **caractérisé en ce que** les surfaces optiquement réfringentes de la micro-optique (14) sont non sphériques, pour une adaptation de la divergence de la lumière émise (16) des sources de lumière.

4. Dispositif de formation d'image pour une forme d'impression (29), selon l'une des revendications précédentes, **caractérisé en ce que** l'agencement optique (10) d'un miroir convexe (26) et d'un miroir concave (24) présente au moins un segment circulaire d'une optique à symétrie de révolution, dont la ligne circulaire d'objet (36) associée présente par rapport à la projection de la série des pointa d'image intermédiaires virtuels (38), qui s'étend sensiblement de manière rectiligne, une distance choisie d'une faible valeur.

5. Dispositif de formation d'image pour une forme d'impression (29), selon l'une des revendications précédentes, **caractérisé en ce qu'**il est prévu au moins un élément déviateur de lumière (22) avant et/ou après les surfaces réfléchissantes de l'agencement optique (10) d'un miroir convexe (26) et d'un miroir concave (24), et/ou un élément de formation de faisceau (30) entre les surfaces réfléchissantes de l'agencement optique (10) d' un miroir convexe et d'un miroir concave.

6. Dispositif de formation d'image pour une forme d'impreseion (29), selon l'une des revendications précédentes, **caractérise en ce que** l'agencement optique (10) est au moins en partie d'une construction monolithique.

7. Dispositif de formation d'image pour une forme d'impression (29), selon la revendication 6, **caractérisé en ce que** les surfaces intérieures actives du monolithe (40) sont munies d'un revêtement réfléchissant.

8. Dispositif de formation d'image pour une forme d'impression (29), selon la revendication 6 ou la revendication 7, **caractérisé en ce que** sont prévues au moins une fenêtre d'entrée (32) et une fenêtre de sortie (34) avec des couches anti-réfléchissantes.

9. Dispositif de formation d'image pour une forme d'impression (29), selon l'une des revendications 6 à 8, **caractérisé en ce qu'**à la construction monolithique (40) sont associés d'autres éléments optiques (54, 56, 58) pour la déviation de faisceau et/ou la formation de faisceau et/ou pour la correction du front d'onde.

10. Dispositif de formation d'image pour une forme d'impression (29,) selon l'une des revendications 6 a 9, **caractérisé en ce que** le monolithe (40) comprend un verre avec un indice de réfraction élevé comparé à son environnement.

11. Dispositif d'exposition ou d'irradiation pour forme d'impression, **caractérisé en ce que** le dispositif d'exposition ou d'irradiation pour forme d'impression comprend au moins un dispositif de formation d'image selon l'une des revendications précédentes.

12. Groupe d'impression, **caractérise en ce que** le groupe d'impression comprend au moins un diepositif de formation d'image selon l'une des revendications précédentes.

13. Machine à imprimer comprenant un groupe margeur d'entrée, au moins un groupe d'impression et un groupe de sortie, **caractérisée en ce que** la machine à imprimer comprend au moins un groupe d'impression selon la revendication 12.
